**Europäisches Patentamt**

**European Patent Office**

**Office européen des brevets**

(11) Publication number: **0 032 015**
**B1**

## (12) EUROPEAN PATENT SPECIFICATION

(45) Date of publication of patent specification: **28.02.90**

(21) Application number: **80304531.9**

(22) Date of filing: **16.12.80**

(51) Int. Cl.⁵: **G 11 C 29/00**

(54) **Field programmable device with test-bits.**

(30) Priority: **18.12.79 JP 164333/79**

(43) Date of publication of application:
**15.07.81 Bulletin 81/28**

(45) Publication of the grant of the patent:
**28.02.90 Bulletin 90/09**

(84) Designated Contracting States:
**DE FR GB NL**

(56) References cited:
**EP-A-0 011 974**
**US-A-3 420 991**

**IBM TECHNICAL DISCLOSURE**
**BULLETIN,vol.21,no.10,March 1979,New**
**York,USA FAVRE: "Method of testing ROM**
**modules",page 4065.**
**1974 Semiconductor Test Symposium,Cherry**
**Hill;pages 87-113.**

(73) Proprietor: **FUJITSU LIMITED**
**1015, Kamikodanaka Nakahara-ku**
**Kawasaki-shi Kanagawa 211 (JP)**

(72) Inventor: **Fukushima, Toshitaka**
**1604-442, Shiomidai Isogo-ku**
**Yokohama-shi Kanagawa 235 (JP)**
Inventor: **Koyama, Kazumi**
**3-17-7, Wakabadai Shiroyama-cho**
**Tsukui-gun Kanagawa 220-01 (JP)**
Inventor: **Ueno, Kouji**
**1360, Shukugawara Tama-ku**
**Kawasaki-shi Kanagawa 214 (JP)**

(74) Representative: **Sunderland, James Harry et al**
**HASELTINE LAKE & CO Hazlitt House 28**
**Southampton Buildings Chancery Lane**
**London WC2A 1AT (GB)**

(56) References cited:

**IEEE Spectrum , December 1971 , pages 28-37.**
**Siemens Forschungs- und**
**Entwicklungsberichte , volume 4 , number 4**
**,1975 , pages 245-249 .**

Courier Press, Leamington Spa, England.

# EP 0 032 015 B1

**Description**

The present invention relates generally to the testing of field programmable devices with unprogrammed memory cell parts, for example PROM's (Programmable Read Only Memories), capable of being subjected to functional tests before information is written therein.

In field programmable devices such as PROM's, that is, memory devices capable of having information written therein on the spot, all memory cells within the memory device, before write-in of information, are in a "0" (low) or "1" (high) state, and hence tests cannot be performed to detect whether a memory cell selected is in a normal or abnormal state.

One example of a conventional memory device of the above type comprises $X$ and $Y$ address inverters, an X-decoder driver, a Y-decoder, a memory cell part, a multiplexer, and an output circuit. However, when all the memory cells of the memory cell part are in the same state, even in the event of breakdown of one or more peripheral circuits (address inverters, decoder driver, or output circuit, for example) the contents read-out from the memory cells are all the same. Accordingly, it is impossible to determine whether the cells are in normal or abnormal states, and even upon the assumption that there are abnormalities, it is not possible to determine where the abnormalities exist.

Hence, a system was devised in which a row of extra test bits and a test word are provided within the memory cell part. In this system, by storing codes of predetermined code patterns, "1,0,1,0,...", for example, into the test bit row and test word, a test can be performed for detecting the states of the peripheral circuits, by reading out these code patterns. However, since there are a plurality of items or factors which should be tested in relation to a memory device, the above system is not sufficient insofar as it is only capable of performing certain kinds of tests. Therefore, it is not enough simply to provide a test bit row and a test word within the memory cell part, and write in code patterns such as "1,0,1,0,..."; in addition an ingenious code pattern must be devised. Even such an ingenious code pattern is still not sufficient for performing all the necessary tests, since short-circuits in wiring which occur under certain conditions cannot always be detected.

In view of the above problems, the present applicant has proposed a field programmable device, in European Patent Application No. 79302622.0, publication No. 0 011 974, which falls within the scope of Article 54, paragraph 3, EPC, which can be subjected to various tests, and accordingly is capable of being tested before shipment of the memory device. However, it has been revealed that this system is still imperfect in that the system is incapable of performing complete tests in relation to the operational speed of the memory device. The capacitance of a memory cell in the field programmable device before information is written-in may be different from that after information is written-in. Accordingly, word line capacity varies with respect to the write-in ratio (of cells along the word line).

Variations of word line capacity cause change in rise-up characteristics of a word line and in read-out time. Such changes are generally of small amounts, but since field programmable devices, especially high-speed Schottky-type PROM's and the like, have a fast average access time of 20 nsec in the 4-kilobit class, even the slightest change can become a problem.

Word line capacity is affected by manufacturing processes, and thus, computation of word line capacity by calculation is difficult, and preferably actual measurements should be made.

In the case of the above field programmable device proposed by the Applicant, the write-in ratio of the test bit row and test word are both 50%, and hence the device is capable of being subjected to a speed check relating to a 50% write-in ratio, but incapable of being subjected to speed checks in remaining parts or for other write-in ratios. Therefore, when a user performs a 100% write-in (this is done quite often), access time can be much higher than the nominal value indicated by a 50% write-in check.

IBM Technical Disclosure Bulletin, Vol. 21, No. 10, March 1979, discloses a method of testing ROM modules which are written and tested in the factory before being released to users. During the write operation four addresses are dedicated to test operations. First and last addresses in the memory store respectively a pattern of alternate 1 and 0 bits and an inverted version of that pattern, and addresses 1 and 2 store information relating to the contents of the memory.

US—A—3 420 991 discloses an error detecting system for a ROM. The ROM holds information words and test words which are read in sequence. Each information word contains an indication of whether or not a word next to be read in sequence is a test word and an indication of the address of the next word. If the next word is not of the kind indicated by the preceding word an error is detected. The test words may comprise all 1 bits or all 0 bits.

An article by Waser entitled "What is necessary for testing ROM's and PROM's", published in the Digest of Papers of the 1974 Semi-Conductor Test Symposium, Cherry Hill, New Jersey, November 1974, pages 87—113, discloses a PROM with an additional row and column, each containing alternate "1"'s and "0"'s, for testing output selector circuitry.

There is also disclosed a test for PROM's in which a row containing alternate "1"'s (HIGH's) and "0"'s (LOW's), is zapped with the object of providing the row with all "0"'s (LOW's), for the purpose of testing programmability (i.e. that zapping is performed correctly).

Waser also contains disclosure relating to the dynamic testing of ROM's (non-field programmable).

An article by Kondo entitled "Test Pattern for EPROM's", published in IEEE Journal of Solid State Circuits, Vol. SC 14, No. 4, August 1979, pages 730—734, discloses testing of an EPROM by writing in test

2

bit patterns filling the storage space of the EPROM. Use of an all "1" (or all "0") pattern, a matrix analyzed pattern, a checker and inverted checker patterns is mentioned.

IEEE Spectrum, December 1971, pages 28 to 37, in an article by F. van Veen entitled "An Introduction to IC Testing", discusses testing of digital bipolar IC's, linear IC's and semiconductor memories. It distinguishes between dc parametric and pulse parametric (dynamic) testing. In relation to semiconductor memories, it is said that they are functionally and parametrically tested like other IC's.

Siemens Forschungs- und Entwicklungs-berichte, Vol. 4, No. 4, 1975, at pages 245 to 249, in an article entitled "A High-Speed 1024-bit ECL Programmable Read-Only Memory" mentions that the (32×32) PROM matrix is provided with a 32-bit test area which is addressed separately and which allows checking of static, dynamic and programming performance.

According to the present invention there is provided a method of testing a field programmable device, having an unprogrammed memory cell part, comprising:—

providing a first test bit row, along a bit line of the memory cell part, and/or a first test word row, along a word line of the memory cell part, with a first code pattern, and

testing DC characteristics of the device by reading out from the first code pattern,

characterised by providing the first code pattern as "0,1,1,0,1,0,0,1,...", obtained by setting an address signal bit $A_0$ of an address signal to "1" and forming a code beginning with $\overline{A}_0A_0$, succeeded by an inverted code $A_0\overline{A}_0$ to form a code $\overline{A}_0A_0A_0\overline{A}_0$, succeeded by an inverted code $A_0\overline{A}_0\overline{A}_0A_0$ to form a code $\overline{A}_0A_0A_0\overline{A}_0A_0\overline{A}_0\overline{A}_0A_0$ and so on,

providing a second test bit row, along another bit line of the memory cell part, and/or a second test word row, along another word line of the memory cell part, with a second code pattern, having a write-in ratio significantly different from the write-in ratio of the first code pattern, and

testing access time characteristics of the device, by reading out from the second code pattern.

An embodiment of the present invention can provide field programmable device testing whereby the above-described problems have been overcome.

An embodiment of the present invention can provide for the performance of complete tests on DC and AC characteristics of the field programmable device before the shipment of the device.

Reference is made, by way of example, to the accompanying drawings, in which:—

Fig. 1 is a block diagram illustrating one example of the construction of a previously proposed PROM device;

Fig. 2 is an equivalent circuit diagram of a pn-junction type memory cell part of the device of Fig. 1, showing test bit and test word rows;

Fig. 3A to 3C are, respectively, an equivalent circuit diagram and cross-sections taken along line II and I in the equivalent circuit diagram, of a memory cell part of the device of Fig. 1 in a non-written state;

Fig. 4 is a schematic illustrative diagram of a memory cell part of the device of Fig. 1 for assistance in explanation of the written-in state shown in Fig. 2;

Figs. 5 and 6 are block circuit diagrams illustrating the construction of address inverters, a decoder driver, and a memory cell part of the device of Fig. 1;

Fig. 7 is a schematic diagram showing information to be written into test bits for performing a DC test;

Figs. 8A and 8B are respective block circuit diagrams, and Figs. 9A, and 9B are schematic diagrams for assistance in describing an actual test bit arrangement and its use for performing a DC test;

Fig. 10 is a block circuit diagram of a multiplexer test circuit;

Figs. 11A, 12A and 11B and 12B are, respectively, simplified cross-sectional diagrams of a cell and equivalent circuit diagrams;

Fig. 13 is a schematic diagram for assistance in describing a memory device used in connection with a method embodying the present invention; and

Figs. 14A, 15A, and 16A are respective equivalent circuit diagrams of different types of memory cells, and Figs. 14B, 15B and 16B are corresponding cross-sectional diagrams.

Prior to a description of the present invention, the field programmable device previously proposed by the present Applicant in European Patent Application No. 79302622.0, publication No. 0 011 974, will be described, in order to provide for a ready understanding of the details of the present invention.

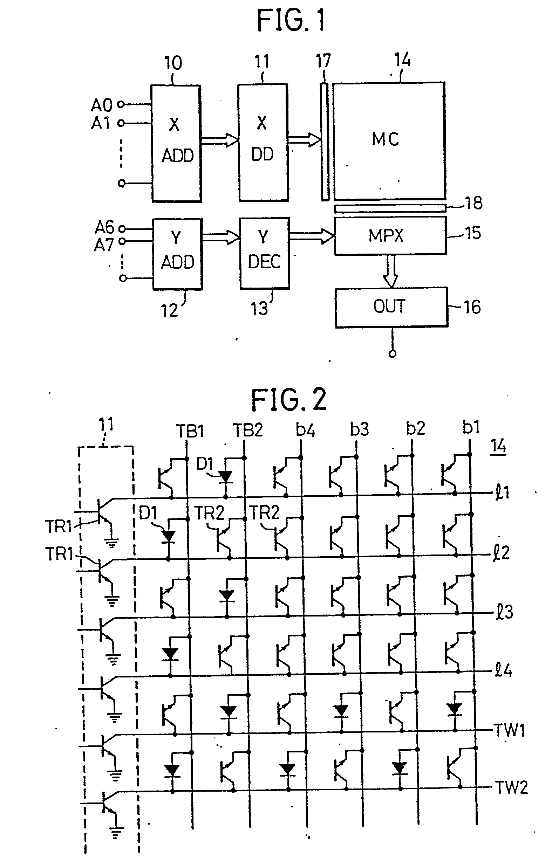

Fig. 1 shows an example of the construction of a PROM device as previously proposed, which comprises *X* and *Y* address inverters 10 and 12, an X-decoder driver 11, a Y-decoder 13, a memory cell part 14, a multiplexer 15, an output circuit 16, and test bit and test word groups 17 and 18.

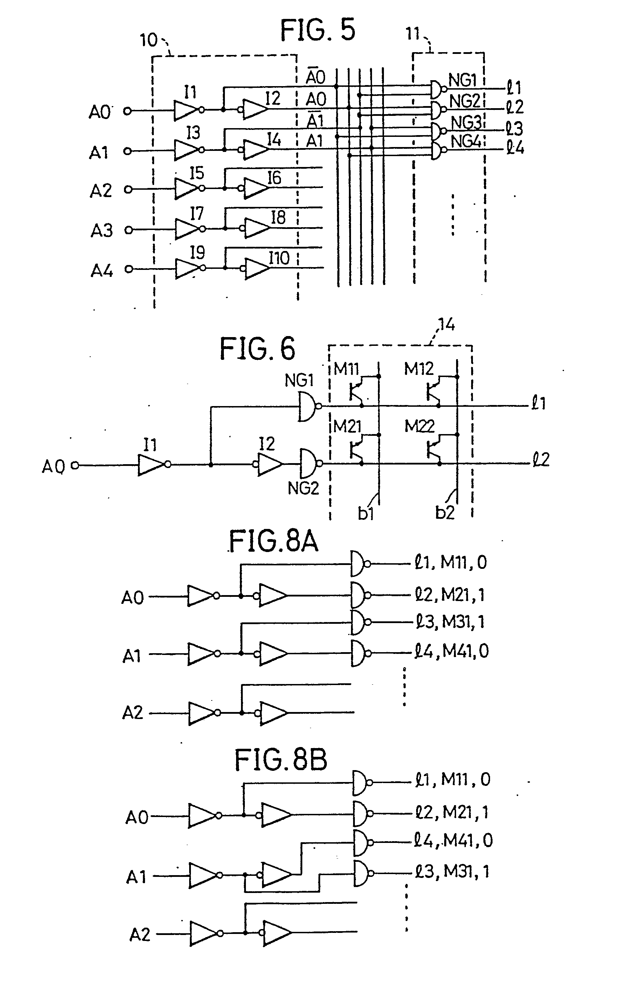

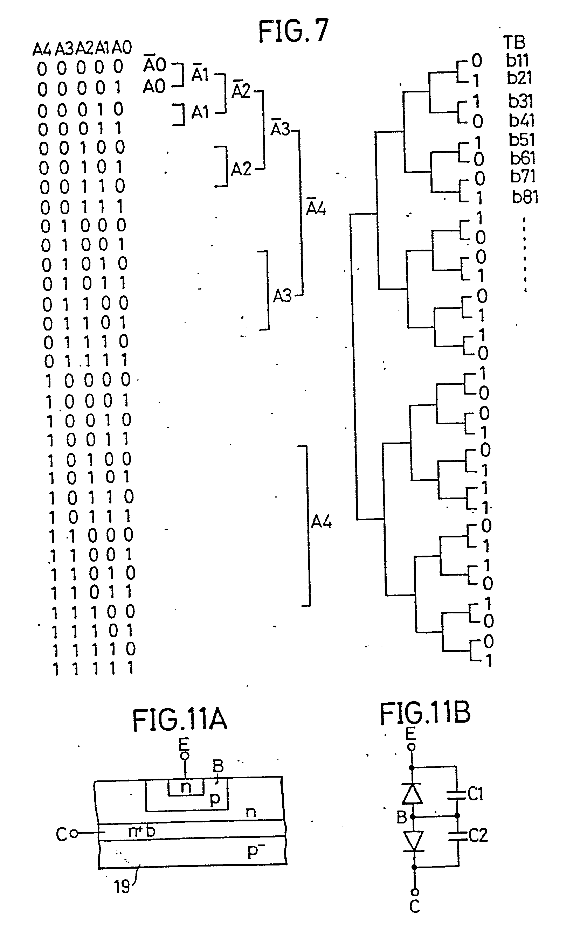

Fig. 2 shows an equivalent circuit diagram of a memory cell part of Fig. 1. In Fig. 2, two test bit rows $TB_1$ and $TB_2$ are provided along with bit lines $b_1$ to $b_4$ on one hand, and two test word rows $TW_1$ and $TW_2$ are provided along with word lines $l_1$ to $l_4$ on the other, within memory cell part 14. A code of a predetermined code pattern, namely "0,1,1,0,1,0,0,1 . . .", is written into the first test bit row $TB_1$ (Fig. 2 does not illustrate this code pattern but rather a code pattern employed in connection with the explanation of Figs. 5 and 6 and Figs. 8B and 9A; the code pattern mentioned above will be understood to relate to Fig. 7). The above code pattern is obtained by setting the address signal bit $A_0$ of the address signal to "1" (high), and forming a code beginning with $\overline{A}_0A_0$, succeeded by an inverted code $A_0\overline{A}_0$ which forms a code $\overline{A}_0A_0A_0\overline{A}_0$, then succeeded by an inverted code $A_0\overline{A}_0\overline{A}_0A_0$ which forms a code $\overline{A}_0A_0A_0\overline{A}_0A_0\overline{A}_0\overline{A}_0A_0$ and so on. A code having a code pattern inverted with respect to that of the first test bit row $TB_1$ is written into the second test bit row $TB_2$. Similarly, predetermined code patterns are written into both the test word rows $TW_1$ and $TW_2$.

Therefore, the states of test bits in test bit rows $TB_1$ and $TB_2$ in corresponding positions are respectively inverted states, and the same is true for the test rows $TW_1$ and $TW_2$.

Transistors $TR_1$ are transistors in output stages of decoder driver 11, which are connected to corresponding word lines $l_1$, $l_2$, . . .. Transistors $TR_2$ represent memory cells not yet having information written therein. Diodes $D_1$ represent diodes formed when transistor emitter and base junctions are short circuited, to show memory cells having written-in information "1" (high).

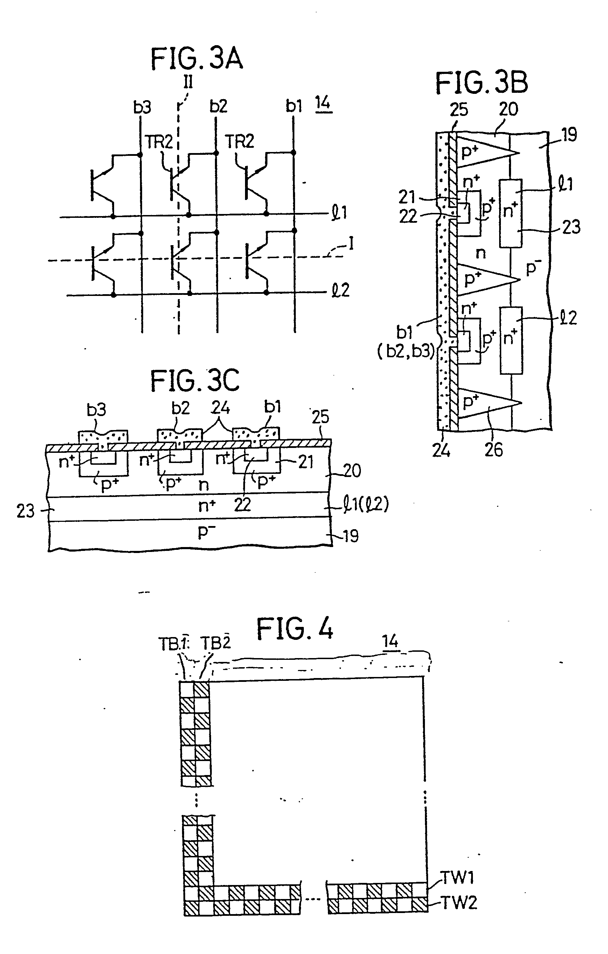

Figs. 3A to 3C are, respectively, an equivalent circuit diagram of the memory cell part not yet having written information therein, and respective cross-sectional diagrams of the memory cell part respectively taken along broken lines I and II of Fig. 3A. In this semiconductor device, an n-type semiconductor layer 20 which is to provide the functions of a collector, is epitaxially grown on a $p^-$-type silicon semiconductor base 19. A plurality of $p^+$-type regions 21 which are to be the bases, are formed on top of the n-type semiconductor layer 20, and $n^+$-type regions 22 are formed on top of the $p^+$-type regions 21. The word lines $l_1$ and $l_2$ are formed by the $n^+$-type regions 23 embedded below the n-type layer 20, while the bit lines $b_1$ to $b_3$ are provided by metal wirings 24 formed on the surface. Layers 25 are insulative membranes, and $p^+$-type isolation regions 26 separate the different word lines.

Fig. 4 is a diagram illustrative of the memory cell part of Fig. 2. In Fig. 4, all the memory cells of the memory cell part 14 are in a state in which information is not written in the cells, but information is written selectively in test bits and the test words. The cells in which information is written are shown by the cross-hatched squares, and the remaining (un-written) cells are shown by unmarked squares.

The reason for the necessity to selectively write in the information "0" and "1" will now be described. The selection of the memory cells is performed by the Y-address inverter 12, Y-decoder 13, and multiplexer 15 in relation to the bit line side, and performed by the X-address inverter 10, and X-decoder driver 11 in relation to the word line side. However, to simplify the description, the latter, concerning the word line side, will be described along with Figs. 5 and 6 which outline circuits for the word line side.

As shown in Fig. 5, the address inverter 10 comprises a plurality of rows each having two inverters connected in series, namely, $l_1$ and $l_2$, $l_3$ and $l_4$, and so on. On the other hand, the decoder driver 11 comprises a plurality of rows each having a NAND-gate, namely, $NG_1$, $NG_2$, and so on. Respective address signal bits $A_0$, $A_1$, $A_2$ . . . of an address signal are applied to respective input terminals of the rows having two series connected inverters. Accordingly, inverted and non-inverted signals, namely, $\overline{A}_0$, $A_0$, $\overline{A}_1$, $A_1$, . . . can be obtained.

In this example, the NAND-gate $NG_1$ is supplied with the signals $\overline{A}_0$ and $\overline{A}_1$, and accordingly generates a "0" (low-level) output when $A_0=A_1=0$, which means that the word line $l_1$ has been selected. On the other hand, the NAND-gate $NG_2$ is supplied with the signals $A_0$ and $\overline{A}_1$, and generates a low-level output when $A_0=1$, and $A_1=0$, which means that the word line $l_2$ has been selected. Similarly, the NAND-gates $NG_3$ and $NG_4$ respectively generate low-level outputs when $A_0=0$ and $A_1=1$, and $A_0=A_1=1$, and respectively select the word lines $l_3$ and $l_4$. A decoder driver 11 corresponding to the two-bit address signal bits $A_0$ and $A_1$, is shown in Figure 5 for this example in which the selection from four word lines is performed by using two bits; however, if an address signal has five address signal bits, namely $A_0$ through $A_4$, word line selection from $2^5$, or thirty-two word lines is possible, and in this case, ten inverters, $l_1$ to $l_{10}$, and thirty-two NAND-gates are required.

Fig. 6 further illustrates a selection system on the word line side and including a portion of the memory cell part 14. In Fig. 6, memory cells $M_{11}$, $M_{12}$, . . . $M_{21}$, $M_{22}$, . . . are respectively provided at each of the intersection points between the word lines $l_1$, $l_2$, . . . and bit lines $b_1$, $b_2$, . . .. Furthermore, to simplify the diagram only the address signal bit $A_0$ of the address signal is shown. Generally, the memory cells of a PROM are constructed of fuses or p-n junctions; in this example the latter is indicated, and the write-in of information is effected by destroying the junction between the base and emitter of an npn-transistor. Accordingly, when this junction is destroyed, in a memory cell, a current flows towards the NAND-gate through the bit line and word line crossing at the cell upon generation of a low-level output by the NAND-gate. On the other hand, when this junction is not destroyed, the above current does not flow. Hence, the former situation, in which the junction is destroyed, indicates a write-in of information "1", and the latter situation, in which the junction is not destroyed, indicates a write-in of the information "0".

In PROM devices, the write-in of information is performed by the user, and the write-in of information is not performed before shipment of the devices by the manufacturer. Hence, because the write-in of information has not been performed, the above current which flows toward the NAND-gate through the bit line and word line upon generation of a low-level output by the NAND-gate, as described above, does not flow upon addressing. Accordingly, it is impossible (for the manufacturer, before write in) to detect whether a desired word line has actually been selected or not, or whether a problem such as a break in the wiring exists or not. In addition, the selection of a word line can be successfully performed only when the address inverters, decoder driver, and their wiring are normal, and therefore, even though assumptions can be made in relation to non-selection of a word line due to abnormalities, it is impossible to detect the whereabouts of the cause.

Test bits can be provided in the memory cell part to overcome the above problem. If it is assumed that the memory cells $M_{11}$, $M_{12}$, . . . of Fig. 6 are for test bits inserted in an additional (test) bit line of the memory cell part, and that a code "1,0,1,0, . . ." are written in these test bits, a current flows and the line $l_1$ is selected when the address signal bit $A_0$ is "0", and, no current flows and the line $l_2$ is selected when the address

signal bit $A_0$ is "1". Accordingly, it can be assumed that the inverter $I_1$, NAND-gate $NG_1$ and their wiring are normal when current flows and does not flow as expected. This test cannot provide for detection of abnormalities in the inverter $I_2$ and NAND-gate $NG_2$; when both the inverter $I_2$ and NAND-gate $NG_2$ are in abnormal states in which the inverter $I_2$ constantly produces low-level output and the NAND-gate $NG_2$ constantly produces high-level output, or when there is a break in the wiring, current would not flow (as expected) in these cases either, and thus it cannot be concluded from the above test alone that the system of the inverter $I_2$ and NAND-gate $NG_2$ is in a normal state.

Accordingly, it becomes necessary to consider the possible combinations of output states of each of the elements shown in Fig. 6. There are three possible output states for inverters, mainly; a normal state, an abnormal state in which output is always "1" (referred to as fixed "1" state hereinafter), and an abnormal state in which output is always "0" (referred to as fixed "0" state hereinafter). Therefore, when two inverters are connected in series, there are "$3 \times 3 = 9$" possible output states. However, the resultant overall output state is the same when the inverter $I_1$ is in a fixed "1" state and the inverter $I_2$ is in a normal state, as when the inverter $I_1$ is in a fixed "1" state and the inverter $I_2$ is in a fixed "0" state. Similarly the result is the same when the inverter $I_1$ is in a fixed "0" state and the inverter $I_2$ is in a normal state, as when the inverter $I_1$ is in a fixed "0" state and the inverter $I_2$ is in a fixed "1" state. Hence there are seven possible output state combinations, as shown in Table 1.

TABLE 1

| Case No. | Input | State of inverter $I_1$ | State of inverter $I_2$ | Output of inverter $I_1$ | Output of inverter $I_2$ | Selection state |
|---|---|---|---|---|---|---|
| (1) | 1<br>0 | normal | normal | 0<br>1 | 1<br>0 | normal |
| (2) | 1<br>0 | normal | fixed "1" | 0<br>1 | 1<br>1 | mixed |
| (3) | 1<br>0 | normal | fixed "0" | 0<br>1 | 0<br>0 | mixed |
| (4) | 1<br>0 | fixed "1" | normal | 1<br>1 | 0<br>0 | fixed |
| (4) | 1<br>0 | fixed "1" | fixed "0" | 1<br>1 | 0<br>0 | fixed |
| (5) | 1<br>0 | fixed "1" | fixed "1" | 1<br>1 | 1<br>1 | multi-plexed |
| (6) | 1<br>0 | fixed "0" | normal | 0<br>0 | 1<br>1 | fixed |
| (6) | 1<br>0 | fixed "0" | fixed "1" | 0<br>0 | 1<br>1 | fixed |
| (7) | 1<br>0 | fixed "0" | fixed "0" | 0<br>0 | 0<br>0 | non-selection |

Of the cases (1) to (7) in Table 1, the only normal state obtained is in case (1), and all the other cases (2) through (7) are abnormal states (cases (2) and (3) are partially normal and partially abnormal, and thus abnormal considered as a whole). The object is to detect the above abnormal cases by use of the test bits, but differences occur according to the contents stored in the test bits, as shown in Table 2.

TABLE 2

| Input | Selected wire | Test bit | (1) | (2) | (3) | (4) | (5) | (6) | (7) | Case |
|---|---|---|---|---|---|---|---|---|---|---|
| 0 | $I_1$ | $M_{11}=1$ | 1 | 1 | 1 | 1 | 1 | 0 | 0 | (I) |
| 1 | $I_2$ | $M_{21}=0$ | 0 | 0 | 0 | 1 | 1 | 0 | 0 | (I) |
| Judgement | | | o | o | o | x | x | x | x | |
| 0 | $I_1$ | $M_{11}=0$ | 0 | 1 | 0 | 0 | 1 | 1 | 0 | (II) |
| 1 | $I_2$ | $M_{21}=1$ | 1 | 1 | 0 | 0 | 1 | 1 | 0 | (II) |
| Judgement | | | o | x | x | x | x | x | x | |

As seen in case (I) of Table 2, when information "1" and "0" is written in the memory cells $M_{11}$ and $M_{21}$ of test bit line $b_1$, respectively, upon normal selection of case (1), the memory cell $M_{11}$ is conductive when the input address signal $A_0$ is "0" and the line $I_1$ is selected, and the memory cell $M_{21}$ is not conductive when the input address signal $A_0$ is "1" and the line $I_2$ is selected. Accordingly, the read-out values of the test bit memory cells $M_{11}$ and $M_{21}$ are "1" and "0", respectively, the same as those values written therein. Hence, this case can be judged as being normal. However, upon mixed selection (inverter $I_1$ is in a normal state, and inverter $I_2$ is in a fixed "1" state) as in case (2), in the case where information "1" and "0" is written in the memory cells $M_{11}$ and $M_{21}$ respectively, when the input address signal $A_0$ is "0" and the line $I_1$ is selected, the memory cell $M_{11}$ conducts, and when the input address signal $A_0$ is "1" and the line $I_2$ is selected, the memory cell $M_{21}$ does not conduct. Therefore, as a result, the read-out contents become the same as those corresponding to written-in contents. But in this case, the case where be judged as being abnormal, since the inverter $I_2$ is in an abnormal state, namely, in a fixed "1" state. Accordingly, the abnormality in the case (2) cannot be detected by this arrangement of the test bit code. The same is true for the case (3), because here too, the abnormality in the inverter $I_2$ cannot be detected by the above coding of the case (I).

On the other hand, when information "0" and "1" is written in the memory cells $M_{11}$ and $M_{21}$ of the test bit line $b_1$, respectively, the contents of the written-in and read-out information of the above respective memory cells are the same upon normal selection of the case (1). In the mixed selection state of the case (2), there is no current passing through the memory cell $M_{11}$ when the input address signal $A_0$ is "0" and the line $I_1$ is selected since the memory cell $M_{11}$ (transistor) is not conductive, but because the inverter $I_2$ is in a fixed "1" state and the line $I_2$ is selected as well, there is a current flowing through the memory cell $M_{21}$, and the resultant read-out content of the memory cell $M_{11}$ is "1". When the input address signal $A_0$ is "1" and the line $I_2$ is selected, there is a current flowing through the memory cell $M_{21}$, and thus the read-out signal of the memory cell $M_{21}$ becomes "1". Accordingly, the read-out contents "1, 1" differ from the written-in contents "0, 1", and judgement is made that an abnormality exists in this case. This judgement is, of course, correct.

Similarly, correct judgements can be made for all the cases (1) through (7), in case (II) of Table 2. It is thus understood that the write-in contents for the memory cells $M_{11}$ and $M_{21}$ should be $M_{11}=0$ and $M_{21}=1$, and that the other combination (case I) is unacceptable. However, the above description is for the case when the address signal has only one bit, namely $A_0$, and when there are a plurality of bits, for example, in the case of five bits, the acceptable coding is as shown in Fig. 7.

Fig. 7 shows that test bits $b_{11}$ and $b_{21}$, corresponding to the above memory cells $M_{11}$ and $M_{21}$, are respectively "0" and "1" as described above, and that succeeding test bits $b_{31}$ and $b_{41}$ should contain the inverse code of that formed by the test bits $b_{11}$ and $b_{21}$, namely "1" and "0", respectively. The next succeeding test bits $b_{51}$, $b_{61}$, $b_{71}$ and $b_{81}$ should contain the inverse code of that formed by the test bits $b_{11}$, $b_{21}$, $b_{31}$, and $b_{41}$, namely "1,0,0,1". Similarly, the rest of the code can be obtained as shown in Fig. 7, and the same code pattern should be inserted into the test word $TW_1$ to perform the above described valid judgements (see Fig. 2).

By using the above described information (code) to be written-in into the test bits, the address inverters as well as the decoder driver can be checked for normal or abnormal states. However, only the current absorbing capacity of half the decoder drivers can be checked, since the other half of the decoders are connected to bits containing the information "0" (this is because the code pattern contains the same number of "0"s and "1"s).

The write-in of information is performed by selecting a word line, and applying a large voltage on the bit line to pass a large current of about 200 mA through the bit line, memory cell, word line, and NAND-gate. However, this large current cannot be passed through the NAND-gates connected to the test bits in an OFF state, and the current absorbing capacity of the NAND-gates cannot be checked. The object of the above stated invention in European Patent Application No. 79302622.0, publication No. 0 011 974, was to compensate for the above described problems. As seen in Figs. 2 to 4, an additional bit line and an additional word line were provided and a test bit row $TB_2$ and test word row $TW_2$ were connected to these additional lines. Furthermore, the information written-in into these test bit cells were made to be the inverse of those written-in into the first test bit line and first test word line, namely, "1,0,0,1,0, . . ..".

When the code "0,1,1,0,1,0,0,1,1,0, . . ." shown in Fig. 7 is written-in into a test bit line, the second and third test bits, the sixth and seventh test bits, . . ., comprise same contents. Accordingly, the result of tests as outlined above in relation to Tables 1 and 2 would be the same for each of those pairs of test bits if a short-circuit in the wiring thereof existed, and the short-circuit in the wiring cannot be detected. Thus, in the above proposed device, the contents written-in into the test bit pairs mentioned are the same, but the actual physical geographical test bit arrangement in the memory cell part is changed so that the stored contents of those test bits are the inverse of those of their neighbouring test bits (in the same test bit line), namely, "0,1,0,1,0,1 . . ." or "1,0,1,0,1 . . .".

Figs. 8A and 8B illustrate the above described test bit arrangement for a two-bit address signal and four word lines. Fig. 8A shows the case where the code "0,1,1,0" is stored in the test bits (i.e. in actual physical consecutive test bits in a test bit line), and Fig. 8B shows a case where the code "0,1,0,1" is stored in the test bits (i.e. in actual physically consecutive test bits in a test bit line). In either of the above cases, the test bits $b_{11}$, $b_{21}$, $b_{31}$, and $b_{41}$ selected by the two-bit address signals "00", "01", "10", and "11" are written-in with the information "0,1,1,0", respectively, but the actual physical geographical arrangement of bits in the memory cell part in the case shown by Fig. 8B is "0,1,0,1". The circuit of Fig. 8B processes address signal bits differently. Accordingly, by the arrangement shown in Fig. 8B, a different result is obtained when a short-circuit exists between neighbouring wires of a word line, as opposed to that of a normal state, and the abnormality can be detected immediately.

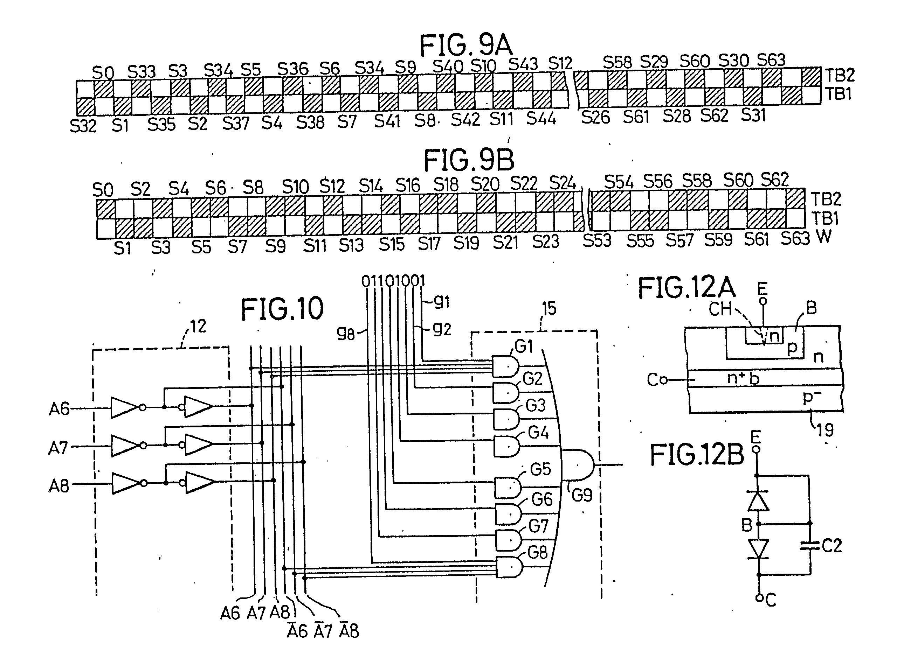

Figs. 9A and 9B respectively show test bit arrangements for six-bit address signal and sixty-four memory cells. Fig. 9A shows a test bit arrangement including a countermeasure against short-circuits in the wiring, while the arrangement of Fig. 9B does not. The cross-hatched squares (bits) indicate bits containing the information "1", and the unmarked squares (bits) indicate bits containing the information "0". In the arrangement of Fig. 9A, besides arranging the bits so that the neighbouring bits (in one line and in different lines) contain the reverse contents from one to another, that is, the neighbouring bits of a bit containing "0" contain "1" and vice versa, the position of the test bits are arranged so that their addresses (of actual consecutive test bit locations) are arranged in an order S32, S0, S1, S33, S35, . . ..

A detection circuit for detecting the defect in the multiplexer is shown in Fig. 10. When memory capacity becomes large, the memory cell part 14 of Fig. 1 is divided into a plurality of memory cell groups, and a system is used in which each of the memory cell groups are selectively connected to the output circuit 16 by use of a multiplexer 15 connected between the output circuit 16 and the memory cell groups. However, this multiplexer 15 also needs to be tested as to whether it is normally operational or not. To perform the above test, a test word can be provided which generates an output representing the output of each of the memory cell groups, and an output can be obtained by switching over these outputs by a switching signal.

In Fig. 10, $G_1$ to $G_8$ are AND-gates, and $G_9$ is an OR-gate constructing the multiplexer 15. Output circuits of each of the memory cell groups are designated by $g_1$ through $g_8$, and selection signals bits for selecting the AND-gates $G_1$ to $G_8$ are designated by $A_6$ through $A_8$. In this example, there are eight memory cell groups, that is, there are eight AND-gates, and hence the output of one of the AND-gates is selected to be high ("1") by the selection signal formed by the three selection signal bits $A_6$ through $A_8$. Abnormalities can be checked by setting a test word to contain "0,1,1,0,1,0,0,1" and considering a possibility of breaks in the wiring, it is desirable to set the physical arrangement of the test word row to contain "0,1,0,1, . . .".

Normal or abnormal state judgement in the above cases (1) through (7), tests on the current absorbing capacity of the decoder driver, and checks for short-circuits in the wiring, can thus be performed in the improved field programmable device described above, and practically complete tests can be performed on the field programmable device in the manufacturing stage and before its shipment. Moreover, the test word and the test bit are used in a similar manner, thus enabling DC tests on the output voltage and output short circuit current, as well as AC tests, and hence judgements can be made on write-in current absorption, multiplexer system, comparing voltages.

However, these AC and DC tests on the peripheral circuits of a memory device, are sufficient only for PROMs and the like having relatively slow operational speeds. In high-speed devices such as high-speed Schottky-type PROM's, the average access time is fast, in the 20 ns range for the 4-kilobit class of device. Accordingly, the AC characteristic of the peripheral circuits within the memory cannot be fully guaranteed merely by providing test words or test bits having a 50% write-in ratio (meaning, there are same number of "0"'s and "1"'s written into the test word or test bit).

A memory cell having no information written-in can be shown as in Figs. 11A and 11B, where Fig. 11B is an equivalent circuit diagram of the memory cell shown in Fig. 11A. On the other hand, a memory cell having information written-in, can be shown as in Figs. 12A and 12B, where Fig. 12B is an equivalent circuit diagram of the memory cell shown in Fig. 12B. As opposed to the memory cell of Fig. 11A in which the junction capacitance $C_1$ between the emitter $E$ and base $B$ in the reverse-biased state, and the junction capacitance $C_2$ between the base $B$ and collector $C$ in the forward-biased state, are connected in series, the memory cell having information written-in only has the capacitance $C_2$ since a conductive channel CH is formed between the emitter $E$ and base $B$ by destroying the emitter-base junction as shown in Fig. 12A. This junction capacitance $C_2$ between the base $B$ and collector $C$ is forward-biased, and therefore, usually does not introduce a problem. However, this capacitance does introduce a problem in this case for the following reasons.

When the emitter-base junction is short-circuited, a pnp-type transistor is formed by the base $B$, collector $C$ (the collector region $n$ and the buried layer $n^+b$), and the base plate 19, and a current flows through this pnp-type transistor upon selection, as can be clearly seen from the diagram of Fig. 12A. Hence, when the word line is non-selected, the base current of pnp-type transistor is cut-off, and the pnp-type transistor accordingly is turned OFF. However, a charge due to the current which has been flowing remains, and thus, until this charge disappears, the word line voltage does not rise to the high ("1") level of non-selection.

The above capacitance $C_2$ is much larger than the capacitance of a non-written cell (approximately equal to the capacitance $C_1$). Accordingly, the capacity of a word line or bit line may become larger than that provided for by test bit lines $TB_1$ and $TB_2$ or test word line $TW_1$ and $TW_2$ having a 50% write-in ratio. That is, in the case of a pn-junction type PROM, the word line or bit line having a 100% write-in ratio has the heaviest load, and when the AC characteristics of the memory device including its internal peripheral circuits is not tested (checked) under such conditions before its shipment, the access time of the memory device under maximum load cannot be guaranteed.

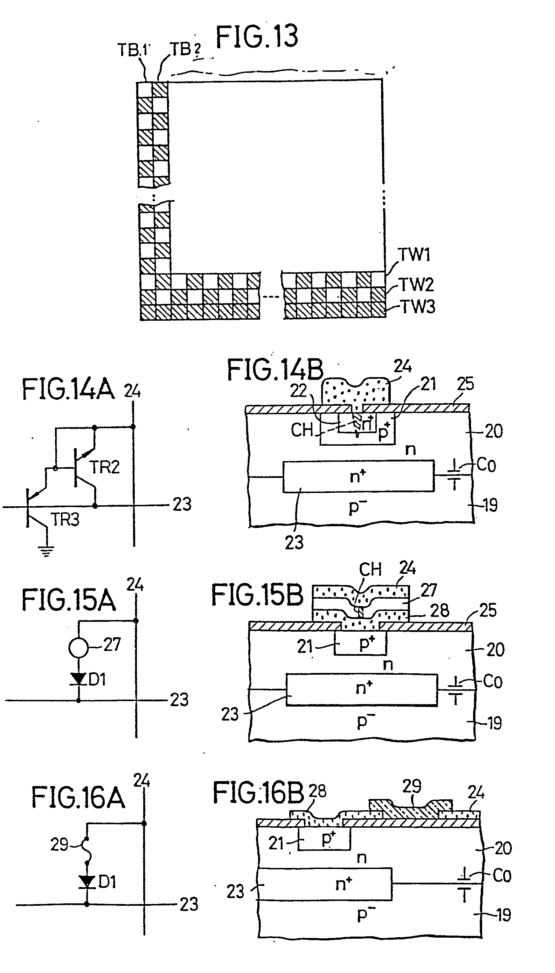

A type of sectional diagram of a memory cell part of a field programmable device used in connection with an embodiment of the present invention is shown in Fig. 13. The point of difference between the present embodiment shown in Fig. 13 from the device shown in Fig. 4 lies on the fact that, in Fig. 13, a third test word $TW_3$ having a write-in ratio of 100% has been added (the cross-hatched squares represent the written-in bits). The test word $TW_3$ is, for example, formed by short-circuiting the emitter-base junctions of all the memory cells in the word line $l_4$ shown in Fig. 2, to convert them into the equivalent of diodes $D_1$.

Fig. 14A shows a more detailed equivalent circuit diagram of a memory cell as illustrated above, and Fig. 14B shows a cross-sectional diagram of the memory cell. In Fig. 14B, those parts that are the same as those corresponding parts in Figs. 3A and 3B are designated by the like reference numbers. A pnp-type transistor (transistor $TR_3$ of Fig. 14A) employing the $p^-$-type semiconductor substrate 19, is parasitically formed. Accordingly, a junction capacitance $C_0$ (capacitance $C_0$ is larger than the above described capacitance $C_1$) is formed between the n-type semiconductor layer 20 and the $p^-$-type semiconductor substrate 19 in the reverse-biased state, and this capacitance $C_0$ acts as a load by the formation of a conducting channel CH. Hence, the capacitance of the written-in cells becomes larger than that of the non-written cells, and the load as seen from the peripheral circuit side differs according to the write-in ratio. Therefore, in accordance with the present embodiment, a test word line $TW_3$ having a maximum load is provided, to guarantee the AC characteristics or the access time of the field programmable device being shipped, by obtaining the slowest access time by the test performed under selection of this additional test word $TW_3$. The test words $TW_1$ and $TW_2$ are also provided, of course, and thus the DC characteristic on the word line side is also fully guaranteed. The same is true on the bit line side, but to describe this would simply repeat the description above, and will be omitted. These test cells for measuring the access time of the memory device can be provided on the test bit side, or on the test word side, or on both the test word and test bit sides.

Moreover, as long as the load is heavy enough to practically guarantee the AC characteristic of the device, the code pattern written-in onto the test word $TW_3$ does not necessarily have to be of a 100% write-in ratio, that is, some bits may be non-written cells. Furthermore, it is also possible to assume (or estimate or evaluate) a slowest access time, by providing two rows of test bits or test words having different write-in ratios between 0% and 100%, and measuring their access time. In this case, one of the test bit or test word rows for performing the DC tests can be used as one of the above test bit and test word rows. Even more, according to the type of memory device being used, it is necessary in some cases to set the code pattern of the test word $TW_3$ to a pattern in which the bits (cells) are all zeros (or nearly all zeros).

Figs. 15A and 15B show a ROM (or EAROM) having memory cells made out of amorphous semiconductor (chalcogenied glass). In this case, the cells have "1" states as in the pn-junction type, but in the case of a fuse type device, the memories (for shipping) must all contain the reverse of the above namely "0"'s as shown in Figs. 16A and 16B. In Figs. 15B and 16B, those parts that are the same as those corresponding parts in Figs. 3A and 3B are designated by the like reference numerals, and their description will be omitted.

In the devices of Figs. 15A and 15B, a chalcogenied glass layer 27 and a metal electrode 28 are inserted between the metal electrode (bit line) 24 and the anode 21 of the diode $D_1$ to provide a bias voltage at the electrodes 24 and 28. By forming a conductive channel CH between these electrodes 24 and 28 by applying a bias current and transforming the single crystal into a polycrystalline structure by Joule heating, write-in is performed. Accordingly, these type of memory cells are of the same type as the pn-junction type cells. However, the cell shown in Figs. 16A and 16B performs the write-in by passing an overcurrent to melt and break a fuse 29. This is of an opposite type to that of the above two examples, and comprises a maximum capacitance in the word line (or bit line) having 100% non-written cells and the capacitance is minimum for the 100% written-in word line (or bit line).

## Claims

1. A method of testing a field programmable device, having an unprogrammed memory cell part (14), and a first test bit row ($TB_1$), along a bit line of the memory cell part (14), and/or a first test word row ($TW_1$), along a word line of the memory cell part (14), with a first code pattern, said method comprising testing DC characteristics of the device by reading out from the first code pattern, and being characterised by

providing the first code pattern as "0,1,1,0,1,0,0,1, . . .", obtained by setting an address signal bit $A_0$ of an address signal to "1" and forming a code beginning with $\overline{A}_0 A_0$, succeeded by an inverted code $A_0 \overline{A}_0$ to form a code $\overline{A}_0 A_0 A_0 \overline{A}_0$, succeeded by an inverted code $A_0 \overline{A}_0 \overline{A}_0 A_0$ to form a code $\overline{A}_0 A_0 A_0 \overline{A}_0 A_0 \overline{A}_0 \overline{A}_0 A_0$ and so on,

providing a second test bit row, along another bit line of the memory cell part (14), and/or a second test word row ($TW_3$), along another word line of the memory cell part (14), with a second code pattern, having a write-in ratio significantly different from the write-in ratio of the first code pattern, and

testing access time characteristics of the device, by reading out from the second code pattern.

2. A method as claimed in claim 1, in which a third test bit row ($TB_2$), along a further bit line of the memory cell part, and/or a third test word row ($TW_2$), along a further word line of the memory cell part (14), is provided with a code pattern inverted with respect to the first code pattern.

3. A method as claimed in claim 1 or 2, in which the first code pattern is arranged so that actual physically geographically neighbouring bits in the row in which that pattern is provided contain inverse information from one bit to the other, e.g. "1"'s and "0"'s.

4. A method as claimed in claim 1, 2 or 3, in which the second code pattern has a 100% write-in ratio, containing all "1"'s.

5. A method as claimed in claim 1, 2 or 3 in which the second code pattern has a 0% write-in ratio, containing all "0"'s.

## Patentansprüche

1. Verfahren zum Testen einer im Feld programmierbaren Einrichtung, mit einem nicht programmierten Speicherzellenteil (14) und einer ersten Testbitreihe ($TB_1$), längs einer Bitleitung des Speicherzellenteils (14), und/oder einer ersten Testwortreihe ($TW_1$), längs einer Wortleitung des Speicherzellenteils (14), mit einem ersten Codemuster, welches genante Verfahren das Testen der Gleichstrom-charakteristiken der Vorrichtung durch Auslesen aus dem ersten Codemuster umfaßt, gekennzeichnet durch

Liefern des ersten Codemusters als "0,1,1,0,1,0,0,1, . . .", welches durch Einstellen eines Adreßsignalbit $A_0$ eines Adressensignals auf "1" erhalten wurde, und Bilden eines Codes, beginnend mit $\overline{A}_0 A_0$, gefolgt durch einen invertierten Code $A_0 \overline{A}_0$, um einen Code $\overline{A}_0 A_0 A_0 \overline{A}_0$ zu bilden, gefolgt von einem invertierten Code $A_0 \overline{A}_0 \overline{A}_0 A_0$, um einen Code $\overline{A}_0 A_0 A_0 \overline{A}_0 A_0 \overline{A}_0 \overline{A}_0 A_0$ zu bilden, usw.,

Liefern, an eine zweite Testbitreihe längs einer anderen Bitleitung des Speicherzellenteils (14), und/oder eine zweite Testwortreihe ($TW_3$), längs einer anderen Wortleitung des Speicherzellenteils (14), eines zweiten Codemusters, welches ein Einschreibverhältnis hat, das von dem Einschreibverhältnis des ersten Codemusters signifikant verschieden ist, und

Testen der Zugriffszeit-Charakteristiken der Vorrichtung durch Auslesen des zweiten Codemusters.

2. Verfahren nach Anspruch 1, bei dem eine dritte Testbitreihe ($TB_2$), längs einer zweiten Bitleitung des Speicherzellenteils, und/oder eine dritte Testwortreihe ($TW_2$), längs einer weiteren Wortleitung des Speicherzellenteils (14), mit einem Codemuster versehen wird, welches in Bezug auf das erste Codemuster invertiert ist.

3. Verfahren nach Anspruch 1 oder 2, bei dem das erste Codemuster so angeordnet ist, daß die tatsächlich physisch-geographisch benachbarten Bits in der Reihe, welche mit dem Muster versehen wird, inverse Information von einem Bit zu dem anderen enthalten, z.B. "1"-en und "0"-en.

4. Verfahren nach Anspruch 1, 2 oder 3, bei dem das zweite Codemuster ein Einschreibverhältnis von 100% hat, nur "1"-en enthält.

5. Verfahren nach einem der Ansprüche 1, 2 oder 3, bei dem das zweite Codemuster ein Einschreibverhältnis von 0% hat, nur "0"-en enthält.

## Revendications

1. Procédé de test d'un dispositif programmable par l'utilisateur, comportant une partie à cellules de mémoire non programmées (14), et une première ligne de bits de test ($TB_1'$), le long d'un fil de bit de la partie à cellules de mémoire (14), et/ou une première ligne de mots de test ($TW_1$), le long d'un fil de mot de la partie à cellules de mémoire (14), avec une première combinaison codée, le procédé consistant à contrôler les caractéristiques en courant continu du dispositif par la lecture de la première combinaison codée, et étant caractérisé en ce qu'il consiste à:

fournir la première combinaison codée comme "0,1,1,0,1,0,0,1, . . .", obtenue en mettant à "1" un bit de signal d'adresse $A_0$ d'un signal d'adresse et former un code commençant par $\overline{A}_0 A_0$, suivi par un code

9

inversé $A_0\overline{A}_0$ pour former un code $\overline{A}_0A_0A_0\overline{A}_0$, suivi par un code inversé $A_0\overline{A}_0\overline{A}_0A_0$ pour former un code $\overline{A}_0A_0A_0\overline{A}_0A_0\overline{A}_0\overline{A}_0A_0$ et ainsi de suite,

fournir une deuxième ligne de bits de test, le long d'un autre fil de bit de la partie à cellules de mémoire (14), et/ou une deuxième ligne de mots de test ($TW_3$), le long d'un autre fil de mot de la partie à cellules de mémoire (14), avec une deuxième combinaison codée, ayant un taux d'écriture notablement différent du taux d'écriture de la première combinaison codée, et à

contrôler les caractéristiques de temps d'accès du dispositif, en lisant la deuxième combinaison codée.

2. Procédé selon la revendication 1, dans lequel est fournie une trosième ligne de bits de test ($TB_2$), le long d'un autre fil de bit de la partie à cellules de mémoire, et/ou une troisième ligne de mots de test ($TW_2$), le long d'un autre fil de mot de la partie à cellules de mémoire (14), avec une combinaison codée inversée par rapport à la première combinaison codée.

3. Procédé selon l'une quelconque des revendications 1 et 2, dans lequel la première combinaison codée est ordonnée de sorte que les bits géographiquement voisins et physiquement présents dans la ligne où est fournie cette combinaison contiennent une information inverse d'un bit à l'autre, par exemple des "1" et des "0".

4. Procédé selon l'une quelconque des revendications 1 à 3, dans lequel la deuxième combinaison codée a un taux d'écriture de 100%, ne contenant que des "1".

5. Procédé selon l'une quelconque des revendications 1 à 3, dans lequel la deuxième combinaison codée a un taux d'écriture de 0%, ne contenant que des "0".

## FIG. 1

## FIG. 2

# FIG. 3A

14

# FIG. 3B

# FIG. 3C

# FIG. 4

FIG. 5

FIG. 6

FIG.8A

FIG.8B

## FIG.7

| A4 | A3 | A2 | A1 | A0 |
|----|----|----|----|----|
| 0 | 0 | 0 | 0 | 0 |
| 0 | 0 | 0 | 0 | 1 |
| 0 | 0 | 0 | 1 | 0 |
| 0 | 0 | 0 | 1 | 1 |
| 0 | 0 | 1 | 0 | 0 |
| 0 | 0 | 1 | 0 | 1 |
| 0 | 0 | 1 | 1 | 0 |
| 0 | 0 | 1 | 1 | 1 |
| 0 | 1 | 0 | 0 | 0 |
| 0 | 1 | 0 | 0 | 1 |
| 0 | 1 | 0 | 1 | 0 |
| 0 | 1 | 0 | 1 | 1 |
| 0 | 1 | 1 | 0 | 0 |
| 0 | 1 | 1 | 0 | 1 |
| 0 | 1 | 1 | 1 | 0 |
| 0 | 1 | 1 | 1 | 1 |
| 1 | 0 | 0 | 0 | 0 |
| 1 | 0 | 0 | 0 | 1 |
| 1 | 0 | 0 | 1 | 0 |
| 1 | 0 | 0 | 1 | 1 |
| 1 | 0 | 1 | 0 | 0 |
| 1 | 0 | 1 | 0 | 1 |
| 1 | 0 | 1 | 1 | 0 |
| 1 | 0 | 1 | 1 | 1 |
| 1 | 1 | 0 | 0 | 0 |
| 1 | 1 | 0 | 0 | 1 |
| 1 | 1 | 0 | 1 | 0 |
| 1 | 1 | 0 | 1 | 1 |
| 1 | 1 | 1 | 0 | 0 |
| 1 | 1 | 1 | 0 | 1 |
| 1 | 1 | 1 | 1 | 0 |
| 1 | 1 | 1 | 1 | 1 |

## FIG.11A

## FIG.11B

## FIG.9A

S0 S33 S3 S34 S5 S36 S6 S34 S9 S40 S10 S43 S12   S58 S29 S60 S30 S63   TB2

TB1

S32 S1 S35 S2 S37 S4 S38 S7 S41 S8 S42 S11 S44   S26 S61 S28 S62 S31

## FIG.9B

S0 S2 S4 S6 S8 S10 S12 S14 S16 S18 S20 S22 S24   S54 S56 S58 S60 S62   TB2

TB1

S1 S3 S5 S7 S9 S11 S13 S15 S17 S19 S21 S23   S53 S55 S57 S59 S61 S63   W

## FIG.10

01101001

g1

g8    g2

12    15

A6

A7

A8

G1
G2
G3
G4
G5
G6
G7
G8

G9

A6 A7 A8

Ā6 Ā7 Ā8

## FIG.12A

E

CH    B

n    p    n

Co    n⁺ b

p⁻

19

## FIG.12B

E

B    C2

C

# FIG.13

TB1 TB2

TW1
TW2
TW3

# FIG.14A

24

TR2

TR3

23

# FIG.14B

22 24 21 25

CH n⁺ p⁺

CH $n^+$ $p^+$

n

$n^+$

$p^-$

20

Co

19

23

# FIG.15A

24

27

D1

23

# FIG.15B

CH 24

27

28 25

21 $p^+$

n

20

$n^+$

Co

$p^-$

19

23

# FIG.16A

24

29

D1

23

# FIG.16B

28 29 24

21 $p^+$

n

20

$n^+$

Co

23

$p^-$

19

6